# EUROPEAN PATENT APPLICATION

(11) **EP 4 546 398 A1**
(43) Date of publication of application: **30.04.2025**
(21) Application number: 23826967.4
(22) Date of filing: 06.06.2023
(51) Int. Cl.: H01L 21/31, C23C 16/52

(54) **VAPOR PHASE GROWTH APPARATUS**

(30) Priority: 22.06.2022 JP 2022100528
(71) Applicant: NuFlare Technology, Inc., Yokohama-shi, Kanagawa 235-8522 (JP)
(72) Inventor: DAIGO, Yoshiaki, Yokohama-shi, Kanagawa 235-8522 (JP); SUZUKI, Kunihiko, Yokohama-shi, Kanagawa 235-8522 (JP)
(74) Representative: Hoffmann Eitle
(86) International application number: PCT/JP2023/020958
(87) International publication number: WO 2023/248780

(57) **Abstract**

A vapor phase growth apparatus according to an embodiment includes: a chamber having a head unit at its upper portion, processing on a wafer being performed inside the chamber; a process gas supply portion provided in the head unit to supply a process gas into the chamber; a recess provided in an upper surface of the head unit; a light-transmitting member including a portion surrounded by the recess, a first distance between a side surface of the portion and a side surface of the recess being larger than a second distance between a bottom surface of the portion and a bottom surface of the recess; a gas introduction portion provided in the head unit to introduce a gas between the side surface of the recess and the side surface of the portion; and a plurality of gas supply portions provided in the head unit and connecting the recess and the chamber to each other to supply the gas into the chamber.

## Description

### TECHNICAL FIELD

The present invention relates to a vapor phase growth apparatus for performing processes such as film deposition or heat treatment on a substrate.

### BACKGROUND ART

In a vapor phase growth apparatus, a film is formed on a substrate by introducing a process gas containing a raw material of the film into a chamber.

In the chamber of the vapor phase growth apparatus, a viewing port may be provided to monitor the substrate temperature, substrate warpage, substrate reflectance, and the like during film formation. Using a viewing port having a light-transmitting window and a measuring instrument provided outside the chamber, it is possible to optically measure the substrate temperature, substrate warpage, substrate reflectance, and the like.

By-products derived from the process gas containing a raw material may adhere to the light-transmitting window of the viewing port. When by-products adhere to the light-transmitting window, the light transmittance of the light-transmitting window changes. The change in the light transmittance of the light-transmitting window is not desirable because the accuracy of optical measurements is reduced. Therefore, it is desirable to suppress the reduction in the accuracy of optical measurements by suppressing the adhesion of by-products to the light-transmitting window.

### CITATION LIST

### PATENT DOCUMENT

Patent Document 1: JP 2013-38196 A

### SUMMARY OF THE INVENTION

### PROBLEM TO BE SOLVED BY THE INVENTION

A problem to be solved by the invention is to provide a vapor phase growth apparatus that suppresses a reduction in the accuracy of optical measurements.

### MEANS FOR SOLVING PROBLEM

A vapor phase growth apparatus according to an aspect of the invention includes: a chamber having a head unit at an upper portion of the chamber, processing on a wafer being performed inside the chamber; a process gas supply portion provided in the head unit to supply a process gas into the chamber; a recess provided in an upper surface of the head unit; a light-transmitting member including a portion surrounded by the recess, a first distance between a side surface of the portion and a side surface of the recess being larger than a second distance between a bottom surface of the portion and a bottom surface of the recess; a gas introduction portion provided in the head unit to introduce a gas between the side surface of the recess and the side surface of the portion; and a plurality of gas supply portions provided in the head unit and connecting the recess and the chamber to each other to supply the gas into the chamber.

### EFFECT OF THE INVENTION

According to the invention, it is possible to realize a vapor phase growth apparatus that suppresses a reduction in the accuracy of optical measurements.

### BRIEF DESCRIPTION OF DRAWINGS

Fig. 1 is a schematic cross-sectional view of a vapor phase growth apparatus according to an embodiment;
Fig. 2 is an enlarged schematic view of a part of the vapor phase growth apparatus according to the embodiment;
Fig. 3 is an enlarged schematic view of a part of the vapor phase growth apparatus according to the embodiment;
Fig. 4 is an enlarged schematic view of a part of the vapor phase growth apparatus according to the embodiment;
Fig. 5 is an enlarged schematic view of a part of the vapor phase growth apparatus according to the embodiment;
Fig. 6 is an enlarged schematic view of a part of the vapor phase growth apparatus according to the embodiment;
Fig. 7 is an enlarged schematic view of a part of the vapor phase growth apparatus according to the embodiment;
Fig. 8 is a schematic diagram when the shape of a gas discharge portion of the embodiment is projected onto the bottom surface of a light-transmitting member;
Fig. 9 is an explanatory diagram of a vapor phase growth method according to a first embodiment;
Fig. 10 is a schematic cross-sectional view of a vapor phase growth apparatus according to a comparative example;
Fig. 11 is an enlarged schematic view of a part of the vapor phase growth apparatus according to the comparative example;
Fig. 12 is an explanatory diagram of a problem of the vapor phase growth apparatus according to the comparative example;
Fig. 13 is an explanatory diagram of the function and effect of the vapor phase growth apparatus according to the embodiment;
Fig. 14 is an explanatory diagram of the function and effect of the vapor phase growth apparatus according to the embodiment;
Fig. 15 is an enlarged schematic view of a part of a vapor phase growth apparatus according to a first modification example of the embodiment;
Fig. 16 is a schematic diagram when the shape of a gas discharge portion in the first modification example of the embodiment is projected onto the bottom surface of a light-transmitting member; and
Fig. 17 is an enlarged schematic view of a part of a vapor phase growth apparatus according to a second modification example of the embodiment.

### MODE(S) FOR CARRYING OUT THE INVENTION

Hereinafter, embodiments of the invention will be described with reference to the diagrams.

In this specification, the same or similar members may be denoted by the same reference numerals.

In this specification, the direction of gravity in a state in which a vapor phase growth apparatus is installed so that a film can be formed is defined as "down", and the opposite direction is defined as "up". Therefore, "lower" means a position in the direction of gravity with respect to the reference, and "downward" means the direction of gravity with respect to the reference. Then, "upper" means a position in a direction opposite to the direction of gravity with respect to the reference, and "upward" means a direction opposite to the direction of gravity with respect to the reference. In addition, the "vertical direction" is the direction of gravity.

In addition, in this specification, "process gas" is a general term for gases used for forming a film, and is a concept including, for example, a source gas, an assist gas, a dopant gas, a carrier gas, and a mixed gas thereof.

A vapor phase growth apparatus according to an embodiment includes: a chamber having a head unit at an upper portion of the chamber, processing on a wafer being performed inside the chamber; a process gas supply portion provided in the head unit to supply a process gas into the chamber; a recess provided in an upper surface of the head unit; a light-transmitting member including a portion surrounded by the recess, a first distance between a side surface of the portion and a side surface of the recess being larger than a second distance between a bottom surface of the portion and a bottom surface of the recess; a gas introduction portion provided in the head unit to introduce a gas between the side surface of the recess and the side surface of the portion; and a plurality of gas supply portions provided in the head unit and connecting the recess and the chamber to each other to supply the gas into the chamber.

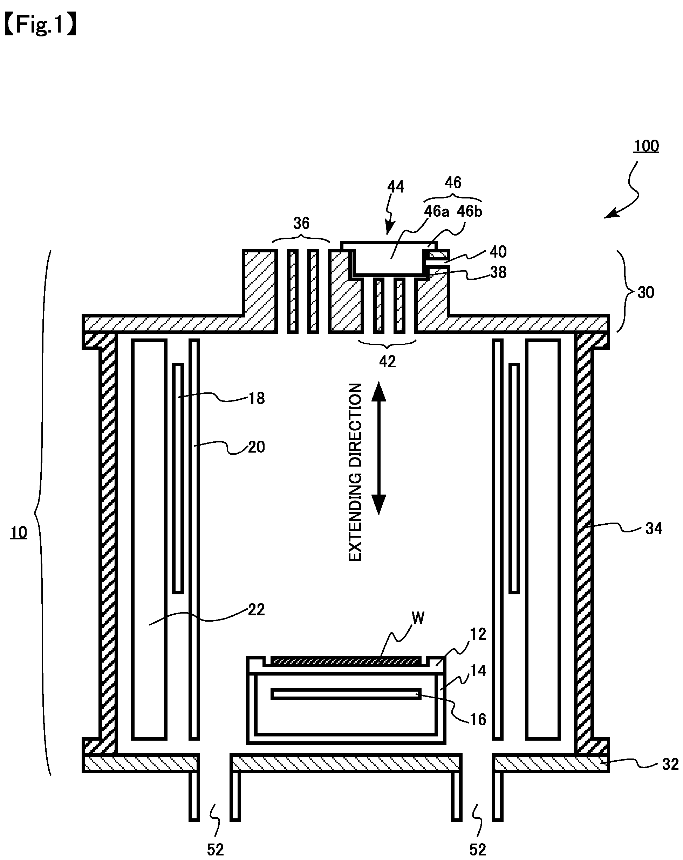

Fig. 1 is a schematic cross-sectional view of a vapor phase growth apparatus according to an embodiment. The vapor phase growth apparatus according to the embodiment is a vapor phase growth apparatus 100. The vapor phase growth apparatus 100 according to the first embodiment is, for example, a single wafer type epitaxial growth apparatus for epitaxially growing a single crystal silicon carbide film on a single crystal silicon carbide substrate.

The vapor phase growth apparatus 100 according to the embodiment includes a chamber 10, a holder 12, a rotating body 14, a lower heater 16, an upper heater 18, a hood 20, and a heat insulator 22. The chamber 10 includes a head unit 30, a lower plate 32, sidewalls 34, and a viewing port 44. The head unit 30 includes a plurality of process gas supply portions 36, a buffer chamber 38 (recess), a purge gas introduction portion 40 (gas introduction portion), and a plurality of purge gas supply portions 42 (gas supply portions). The viewing port 44 includes a light-transmitting window 46 (light-transmitting member) and a fixed portion 48. The lower plate 32 includes a gas exhaust port 52.

The chamber 10 is formed of, for example, stainless steel. In the chamber 10, for example, a silicon carbide film is formed on a wafer W. The wafer W is an example of a substrate. The wafer W is, for example, a semiconductor wafer. The wafer W is, for example, a single crystal silicon carbide wafer.

The chamber 10 includes the head unit 30, the lower plate 32, the sidewalls 34, and the viewing port 44.

The head unit 30 includes a plurality of process gas supply portions 36, the buffer chamber 38 (recess), the purge gas introduction portion 40, and a plurality of purge gas supply portions 42. The lower plate 32 includes the gas exhaust port 52.

The process gas supply portion 36 has, for example, a through hole that reaches the inside of the chamber 10 from the upper surface of the head unit 30. The process gas supply portion 36 has a function of supplying a process gas into the chamber 10. The process gas supplied from the plurality of process gas supply portions 36 contains, for example, a source gas for forming a silicon carbide film on the wafer W.

The buffer chamber 38 is a recess provided in the upper portion of the head unit 30. The buffer chamber 38 is provided on the upper surface of the head unit 30. The buffer chamber 38 is provided below the viewing port 44.

The purge gas introduction portion 40 has, for example, a through hole that reaches from the side surface of the head unit 30 to the side surface of the buffer chamber 38. The purge gas introduction portion 40 has a function of introducing a purge gas (gas) into the buffer chamber 38 from the side surface of the buffer chamber 38. The purge gas introduction portion 40 introduces a purge gas between the side surface of the buffer chamber 38 and the side surface of a protruding portion 46a of the light-transmitting window 46. By introducing the purge gas into the buffer chamber 38, adhesion of by-products to the light-transmitting window 46 of the viewing port 44 is suppressed.

The plurality of purge gas supply portions 42 have, for example, through holes that reach the inside of the chamber 10 from the bottom surface of the buffer chamber 38. The purge gas supply portions 42 extend in the direction of gravity, for example.

The purge gas supply portion 42 has a function of supplying a purge gas from the buffer chamber 38 to the inside of the chamber 10. In addition, the purge gas supply portion 42 functions as a path through which light passes when the state of the wafer W is optically measured. The wafer W is provided in the extending direction of the purge gas supply portion 42.

The process gas supply portion 36 is, for example, a hole penetrating the head unit 30. For example, a part or entirety of the process gas supply portion 36 may be tubular. The purge gas introduction portion 40 is, for example, a hole penetrating the side surface of the head unit 30. For example, a part or entirety of the purge gas introduction portion 40 may be tubular. The purge gas supply portion 42 is, for example, a hole penetrating the head unit 30. For example, a part or entirety of the purge gas supply portion 42 may be tubular.

The viewing port 44 is provided above the head unit 30. For example, the temperature of the wafer W, the warpage of the wafer W, the reflectance of the wafer W, and the like can be optically measured using a measuring instrument (not shown) provided outside the chamber 10 and the viewing port 44 having the light-transmitting window 46.

The gas exhaust port 52 is provided in the lower plate 32. The gas exhaust port 52 has a function of discharging a process gas, a by-product gas, a purge gas, and the like from the inside of the chamber 10 to the outside.

The sidewalls 34 are provided between the head unit 30 and the lower plate 32. The sidewall 34 has, for example, a cylindrical shape.

The holder 12 is provided inside the chamber 10. The wafer W can be placed on the holder 12.

The holder 12 is placed on the rotating body 14. The rotating body 14 is fixed to a rotating shaft (not shown).

The rotating shaft can be rotated by a rotation driving mechanism (not shown). The holder 12 can be rotated by rotating the rotating shaft. By rotating the holder 12, it is possible to rotate the wafer W placed on the holder 12.

The lower heater 16 is provided below the holder 12. The lower heater 16 is provided inside the rotating body 14. The lower heater 16 heats the wafer W held by the holder 12 from below.

The upper heater 18 is provided between the hood 20 and the sidewall 34. The upper heater 18 is located above the holder 12. The upper heater 18 heats the wafer W held by the holder 12 from above.

The hood 20 has, for example, a cylindrical shape. The hood 20 has a function of preventing the process gas from coming into contact with the upper heater 18, for example. The hood 20 has, for example, a function of rectifying the process gas.

The heat insulator 22 is provided between the upper heater 18 and the sidewall 34.

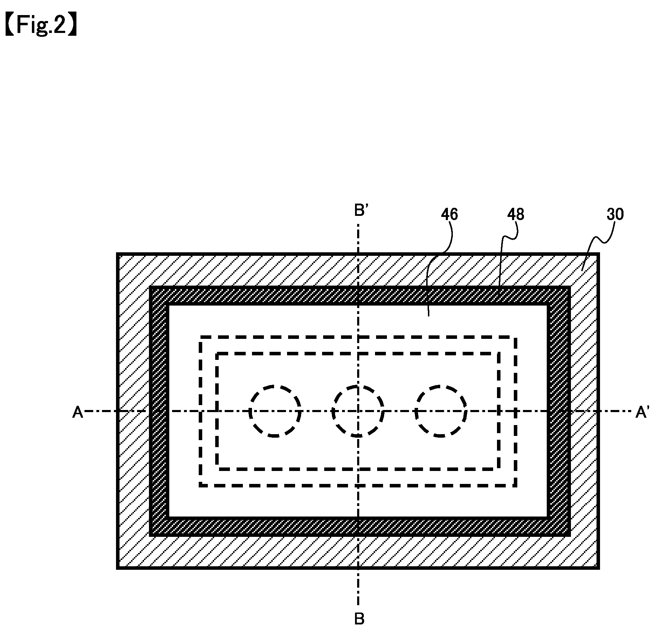

Figs. 2, 3, 4, 5, 6, and 7 are enlarged schematic views of a part of the vapor phase growth apparatus according to the embodiment. Figs. 2 to 7 are enlarged schematic cross-sectional views of the vicinity of the viewing port 44 of the vapor phase growth apparatus 100.

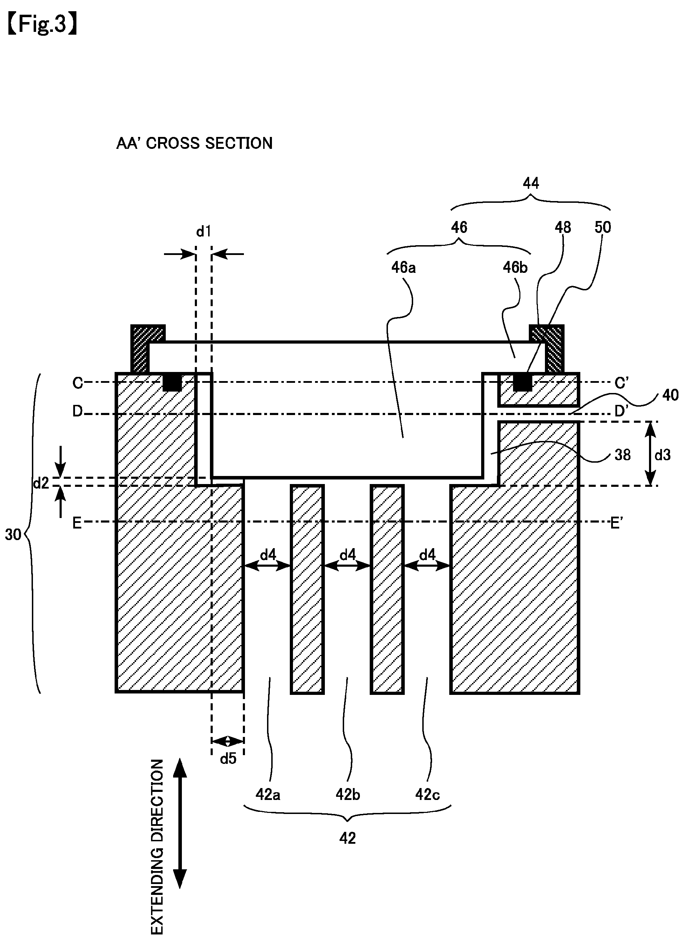

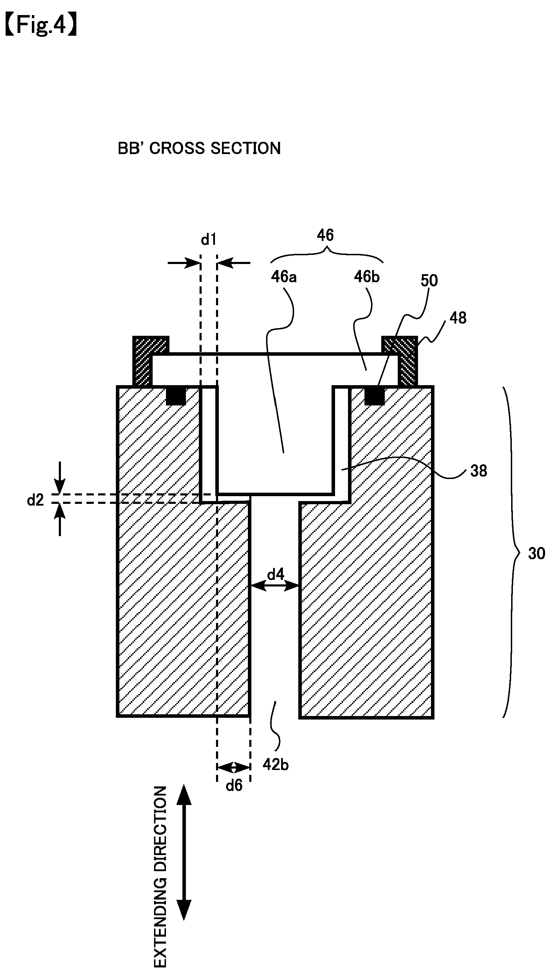

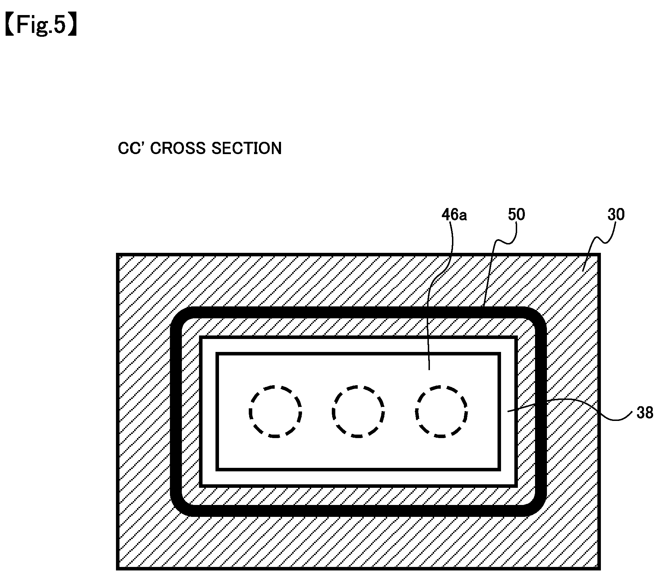

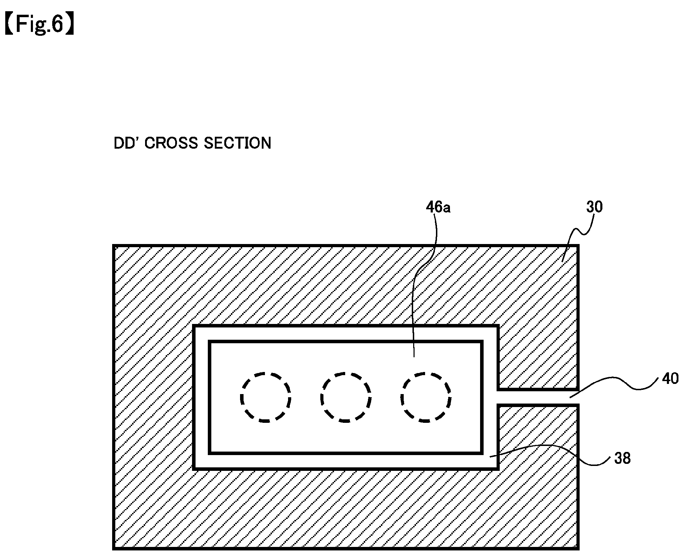

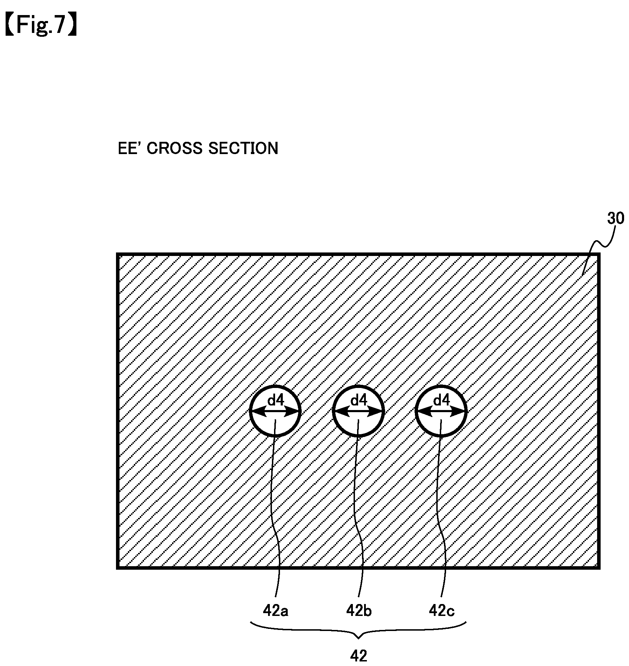

Fig. 2 is a top view of the vicinity of the viewing port 44. Fig. 3 is a cross-sectional view taken along the line AA' of Fig. 2. Fig. 4 is a cross-sectional view taken along the line BB' of Fig. 2. Fig. 5 is a cross-sectional view taken along the line CC' of Fig. 3. Fig. 6 is a cross-sectional view taken along the line DD' of Fig. 3. Fig. 7 is a cross-sectional view taken along the line EE' of Fig. 3.

The viewing port 44 includes the light-transmitting window 46 (light-transmitting member), a fixed portion 48, and a sealing member 50.

The light-transmitting window 46 has the protruding portion 46a and a flange 46b. The light-transmitting window 46 is fixed to the head unit 30 by the fixed portion 48.

The light-transmitting window 46 is formed of a material that is transparent to light. The light-transmitting window 46 is formed of, for example, quartz glass.

The flange 46b is provided at the end of the buffer chamber 38. The sealing member 50 is provided between the flange 46b and the head unit 30. The sealing member 50 has a function of maintaining the airtightness of the inside of the chamber 10. The sealing member 50 is, for example, an O-ring.

As shown in Figs. 3 and 4, the protruding portion 46a is provided inside the buffer chamber 38. As shown in Figs. 5 and 6, the protruding portion 46a is surrounded by the buffer chamber 38. The side surface and the bottom surface of the protruding portion 46a are surrounded by the buffer chamber 38.

There is a first distance (d1 in Figs. 3 and 4) between the side surface of the protruding portion 46a and the side surface of the buffer chamber 38. The first distance d1 is, for example, equal to or more than 1 mm and equal to or less than 5 mm.

In addition, there is a second distance (d2 in Figs. 3 and 4) between the bottom surface of the protruding portion 46a and the bottom surface of the buffer chamber 38.

The second distance d2 is equal to or less than the first distance d1. The second distance d2 is, for example, equal to or more than 0.2 mm and equal to or less than 2 mm.

As shown in Fig. 3, the purge gas introduction portion 40 is provided on the side surface of the buffer chamber 38. The purge gas introduction portion 40 connects the outside of the head unit 30 and the buffer chamber 38 to each other. The purge gas introduction portion 40 is, for example, a hole penetrating the head unit 30.

As shown in Fig. 3, a third distance (d3 in Fig. 3) between the purge gas introduction portion 40 and the bottom surface of the buffer chamber 38 in the extending direction of the purge gas supply portion 42 is larger than the second distance (d2 in Fig. 3) between the bottom surface of the protruding portion 46a and the bottom surface of the buffer chamber 38. In addition, as shown in Fig. 6, the purge gas introduction portion 40 faces, for example, the side surface of the protruding portion 46a.

As shown in Figs. 3 and 7, the plurality of purge gas supply portions 42 include a first purge gas supply portion 42a, a second purge gas supply portion 42b, and a third purge gas supply portion 42c. In the embodiment, an example will be described in which the number of purge gas supply portions 42 is three, but the number of purge gas supply portions 42 may be two or four or more.

The first purge gas supply portion 42a, the second purge gas supply portion 42b, and the third purge gas supply portion 42c reach the inside of the chamber 10 from the bottom surface of the buffer chamber 38. In other words, one end of each of the first purge gas supply portion 42a, the second purge gas supply portion 42b, and the third purge gas supply portion 42c is located at the bottom surface of the buffer chamber 38, and the other end is located at the bottom surface of the head unit 30.

As shown in Fig. 7, in a cross section perpendicular to the extending direction of the purge gas supply portion 42, the shape of the purge gas supply portion 42 is, for example, a circle. In addition, the shape of the purge gas supply portion 42 in the above cross section is not limited to a circle, but may be, for example, an ellipse or a polygon.

The second distance (d2 in Figs. 3 and 4) between the bottom surface of the protruding portion 46a and the bottom surface of the buffer chamber 38 is smaller than, for example, the maximum opening width (d4 in Figs. 3, 4, and 7) of the purge gas supply portion 42. In addition, the first distance (d1 in Figs. 3 and 4) between the side surface of the protruding portion 46a and the side surface of the buffer chamber 38 is smaller than, for example, the maximum opening width (d4 in Figs. 3 and 7) of the purge gas supply portion 42. The maximum opening width d4 of the purge gas supply portion 42 is, for example, equal to or more than 10 mm and equal to or less than 50 mm.

In addition, the maximum opening width d4 of the purge gas supply portion 42 is defined as the maximum distance between any two points on the circumference of the purge gas supply portion 42 in a cross section perpendicular to the extending direction of the purge gas supply portion 42. For example, when the shape of the purge gas supply portion 42 in the above cross section is a circle like the purge gas supply portion 42 of the embodiment, the maximum opening width d4 of the purge gas supply portion 42 is the diameter of the circle.

The bottom surface of the protruding portion 46a faces all regions of the openings of the plurality of purge gas supply portions 42 in the extending direction of the purge gas supply portions 42.

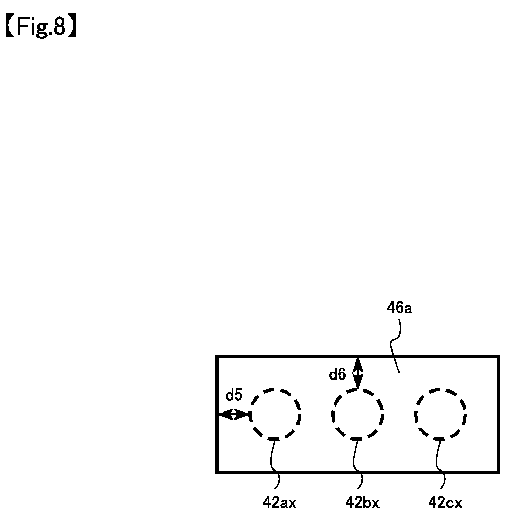

Fig. 8 is a schematic diagram when the shape of a gas discharge portion of the embodiment is projected onto the bottom surface of a light-transmitting member. As shown in Fig. 8, when the shape of the purge gas supply portion 42 is projected at the same size onto the bottom surface of the light-transmitting window 46 in the extending direction of the purge gas supply portion 42, the projected shape of the purge gas supply portion 42 is included within the bottom surface of the light-transmitting window 46. The shapes of the first purge gas supply portion 42a, the second purge gas supply portion 42b, and the third purge gas supply portion 42c projected onto the bottom surface of the light-transmitting window 46 in the extending direction of the purge gas supply portion 42 are a projected shape 42ax, a projected shape 42bx, and a projected shape 42cx, respectively.

The projected shape 42ax, the projected shape 42bx, and the projected shape 42cx are all included within the bottom surface of the light-transmitting window 46. In other words, the projected shape 42ax, the projected shape 42bx, and the projected shape 42cx are all located inside the outer periphery of the bottom surface of the light-transmitting window 46.

As shown in Fig. 8, the distance between each of the projected shape 42ax, the projected shape 42bx, and the projected shape 42cx and the outer periphery of the bottom surface of the light-transmitting window 46 is a fifth distance d5 or a sixth distance d6. As shown in Figs. 3 and 4, the distance between the protruding portion 46a and the purge gas supply portion 42 in a direction perpendicular to the extending direction of the purge gas supply portion 42 is also the fifth distance d5 or the sixth distance d6. The fifth distance d5 and the sixth distance d6 are, for example, larger than the second distance d2.

Next, an example of a vapor phase growth method using the vapor phase growth apparatus 100 according to the embodiment will be described. Hereinafter, a case where a single crystal silicon carbide film doped with nitrogen as an n-type impurity is formed on the surface of the wafer W formed of single crystal silicon carbide will be described as an example. In addition, a case where the temperature of the surface of the wafer W is measured using the viewing port 44 and a measuring instrument provided outside the chamber 10 will be described as an example.

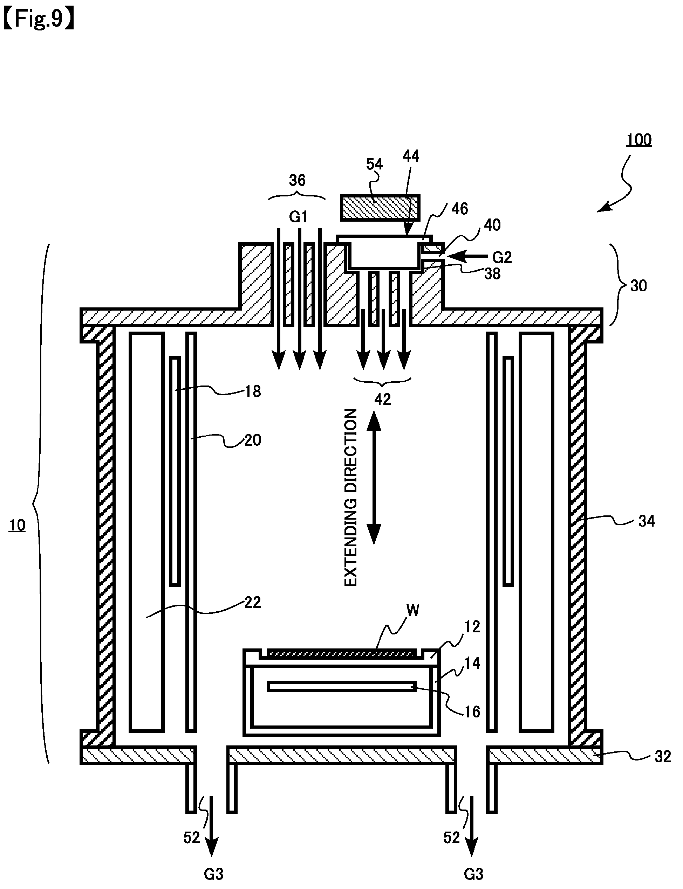

Fig. 9 is an explanatory diagram of the vapor phase growth method according to the embodiment. A measuring instrument 54 is provided above the viewing port 44. The measuring instrument 54 is, for example, a pyrometer capable of measuring the temperature of the surface of the wafer W.

First, the wafer W is placed on the holder 12. The wafer W is a single crystal silicon carbide wafer.

Then, the wafer W is rotated by a rotation driving mechanism (not shown). Then, the wafer W is heated by the lower heater 16 and the upper heater 18.

Then, as shown in Fig. 9, a process gas G1 is supplied from a plurality of process gas supply portions 36 into the chamber 10.

The process gas G1 is, for example, a mixed gas containing a silicon source gas, a carbon source gas, an n-type impurity dopant gas, an assist gas, and a carrier gas. The silicon source gas is, for example, a silane gas (SiH₄). The carbon source gas is, for example, a propane gas (C₃H₈). The n-type impurity dopant gas is, for example, a nitrogen gas (N₂). The assist gas is, for example, a hydrogen chloride gas (HCl). The carrier gas is, for example, an argon gas (Ar) or a hydrogen gas (H₂).

A single crystal silicon carbide film doped with nitrogen as an n-type impurity is formed on the surface of the wafer W by decomposition and reaction of the process gas G1.

For example, at the same time as the process gas G1 is supplied into the chamber 10, a purge gas G2 is introduced into the buffer chamber 38 from the purge gas introduction portion 40. The purge gas G2 introduced into the buffer chamber 38 is supplied from the buffer chamber 38 into the chamber 10 through a plurality of purge gas supply portions 42.

By making the purge gas G2 flow from the buffer chamber 38 into the chamber 10, it is possible to suppress the flow of the process gas G1 into the buffer chamber 38. In addition, by making the purge gas G2 flow from the buffer chamber 38 into the chamber 10, the generation of turbulence in the process gas G1 inside the chamber 10 is suppressed. The purge gas G2 is, for example, a hydrogen gas or an argon gas.

For example, the temperature of the surface of the wafer W is measured by receiving light passing through the purge gas supply portion 42 and the light-transmitting window 46 with the measuring instrument 54 during the formation of a silicon carbide film. The temperature of the surface of the wafer W is measured using the viewing port 44 and the measuring instrument 54. By providing the three purge gas supply portions 42, it is possible to simultaneously measure temperatures at three locations of the center of the wafer W, the outer periphery of the wafer W, and between the center and the outer periphery of the wafer W, for example.

As shown in Fig. 9, during the formation of the silicon carbide film, an exhaust gas G3 is exhausted from the gas exhaust port 52 to the outside of the chamber 10. The exhaust gas G3 contains, for example, the unreacted process gas G1 and the purge gas G2.

After the single crystal silicon carbide film is formed, for example, the supply of the process gas G1 into the chamber 10 and the supply of the purge gas G2 into the buffer chamber 38 are stopped. In addition, heating by the lower heater 16 and the upper heater 18 is stopped to lower the temperature of the wafer W. Thereafter, the wafer W is unloaded from the chamber 10.

Next, the function and effect of the vapor phase growth apparatus 100 according to the embodiment will be described.

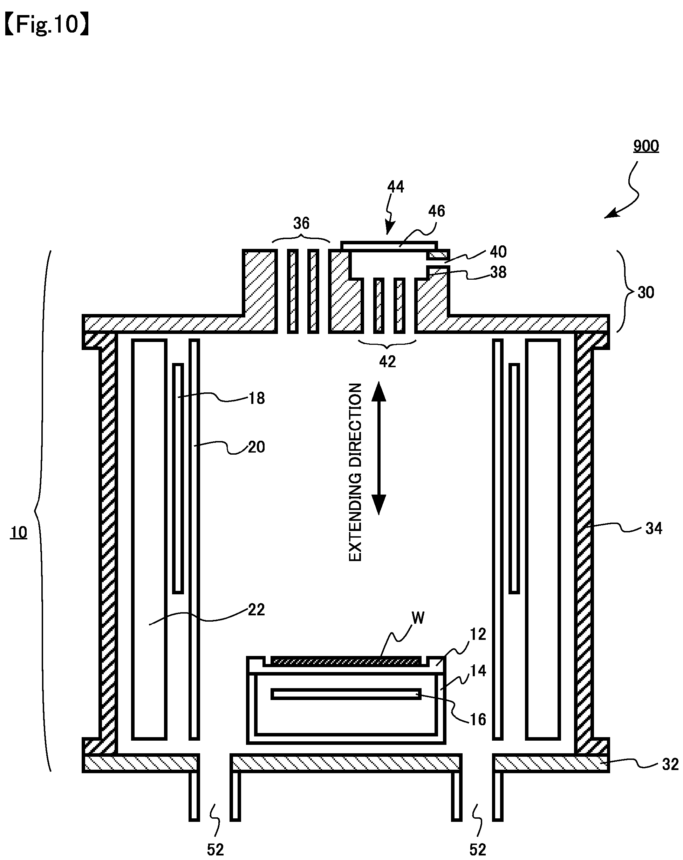

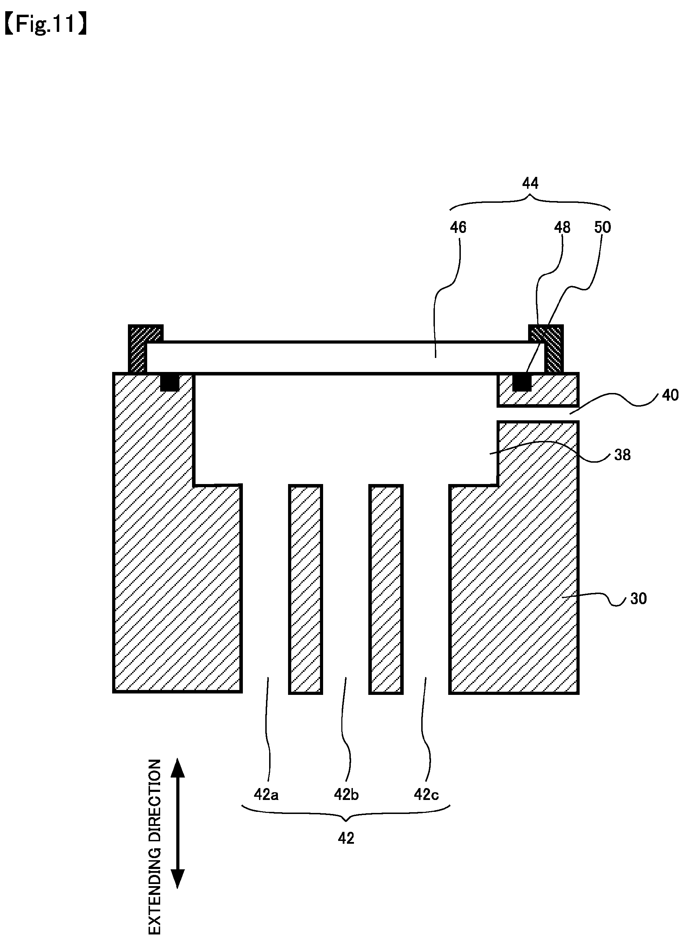

Fig. 10 is a schematic cross-sectional view of a vapor phase growth apparatus according to a comparative example. Fig. 11 is an enlarged schematic view of a part of the vapor phase growth apparatus according to the comparative example. Fig. 10 is a diagram corresponding to Fig. 1 of the embodiment. Fig. 11 is a diagram corresponding to Fig. 3 of the embodiment.

The vapor phase growth apparatus according to the comparative example is a vapor phase growth apparatus 900. As shown in Figs. 10 and 11, the vapor phase growth apparatus 900 according to the comparative example is different from the vapor phase growth apparatus 100 according to the embodiment in that the light-transmitting window 46 does not have the protruding portion 46a. The light-transmitting window 46 according to the comparative example has a flat plate shape.

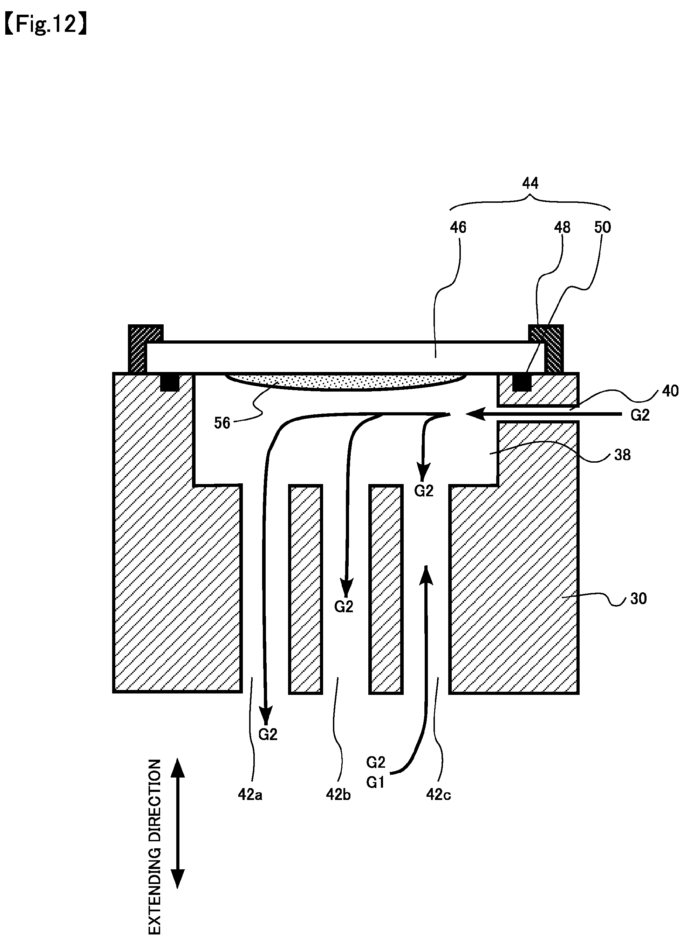

Fig. 12 is an explanatory diagram of a problem of the vapor phase growth apparatus according to the comparative example. Fig. 12 is a diagram corresponding to Fig. 11. Fig. 12 shows the flow of the purge gas G2 or the process gas G1 when a film is formed using the vapor phase growth apparatus 900.

As shown in Fig. 12, the purge gas G2 introduced horizontally from the purge gas introduction portion 40 to the buffer chamber 38 has a high horizontal flow velocity. Therefore, the flow rate of the purge gas G2 flowing to the first purge gas supply portion 42a farthest from the purge gas introduction portion 40 increases. In addition, the flow rate of the purge gas G2 flowing to the third purge gas supply portion 42c closest to the purge gas introduction portion 40 decreases.

Since the flow rate of the purge gas G2 flowing to the first purge gas supply portion 42a is large and the flow rate of the purge gas G2 flowing to the third purge gas supply portion 42c is small, there is a risk that the purge gas G2 or the process gas G1 will flow back from the third purge gas supply portion 42c to the buffer chamber 38.

When the process gas G1 containing the source gas flows into the buffer chamber 38, the process gas G1 may decompose or react in the buffer chamber 38 and accordingly, by-products 56 may adhere to the lower surface of the light-transmitting window 46. When the by-products 56 adhere to the light-transmitting window 46, the light transmittance of the light-transmitting window 46 changes. The change in the light transmittance of the light-transmitting window 46 is not desirable because the accuracy of optical measurements is reduced. In addition, in Fig. 12, the by-products 56 adhere to positions of the light-transmitting window 46 in the extending direction of the first purge gas supply portion 42a, the second purge gas supply portion 42b, and the third purge gas supply portion 42c. However, the by-products 56 may adhere to a position of the light-transmitting window 46 in the extending direction of any one of the first purge gas supply portion 42a, the second purge gas supply portion 42b, and the third purge gas supply portion 42c.

The difference in the flow rate of the purge gas G2 flowing to the first purge gas supply portion 42a, the second purge gas supply portion 42b, and the third purge gas supply portion 42c is believed to be due to the large combined conductance from the purge gas introduction portion 40 to the inside of the chamber 10. Therefore, it is thought that the reason why the purge gas G2 or the process gas G1 flows back from the third purge gas supply portion 42c to the buffer chamber 38 is that the combined conductance from the purge gas introduction portion 40 to the inside of the chamber 10 is large.

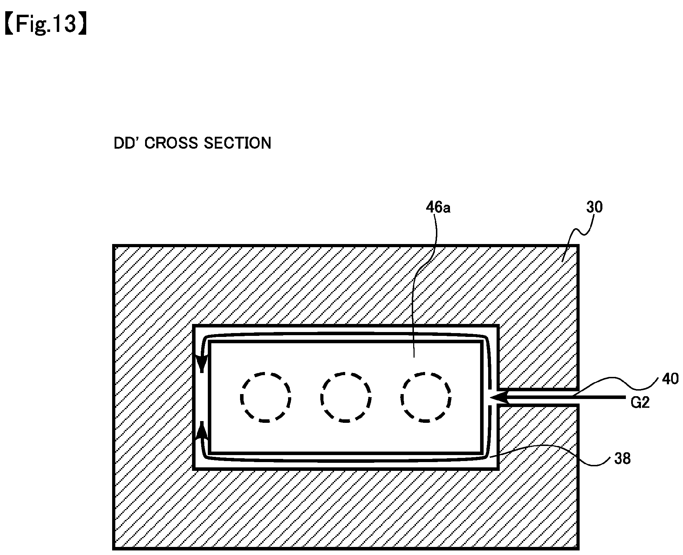

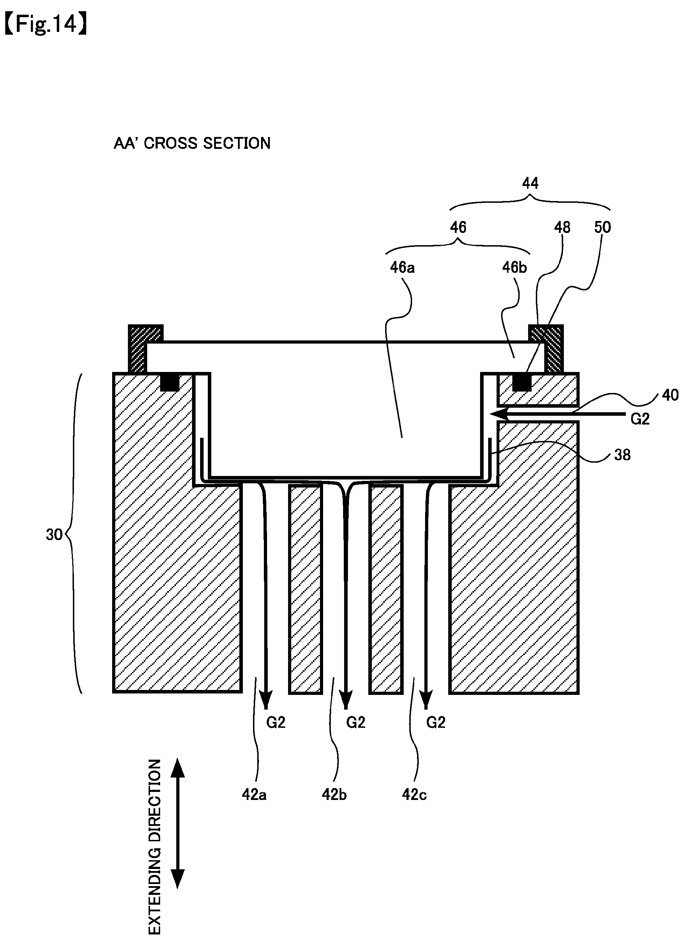

Figs. 13 and 14 are explanatory diagrams of the function and effect of the vapor phase growth apparatus according to the embodiment. Fig. 13 is a diagram corresponding to Fig. 6. Fig. 14 is a diagram corresponding to Fig. 3. Figs. 13 and 14 show the flow of the purge gas G2 when a film is formed using the vapor phase growth apparatus 100.

As shown in Figs. 13 and 14, the purge gas G2 supplied horizontally from the purge gas introduction portion 40 to the buffer chamber 38 flows to the purge gas supply portion 42 through a gap between the protruding portion 46a of the light-transmitting window 46 and the buffer chamber 38. By providing the protruding portion 46a, the flow velocity of the purge gas G2 becomes smaller than that in the comparative example. This is because the combined conductance from the purge gas introduction portion 40 to the inside of the chamber 10 becomes smaller than that in the comparative example by providing the protruding portion 46a.

By reducing the combined conductance from the purge gas introduction portion 40 to the inside of the chamber 10, the flow rates of the purge gas G2 flowing to the first purge gas supply portion 42a, the second purge gas supply portion 42b, and the third purge gas supply portion 42c are more easily equalized than in the comparative example. In particular, by making the second distance d2 between the bottom surface of the protruding portion 46a and the bottom surface of the buffer chamber 38 equal to or less than the first distance d1 between the side surface of the protruding portion 46a and the side surface of the buffer chamber 38, the flow rate of the purge gas G2 in the first purge gas supply portion 42a, which is the farthest from the purge gas introduction portion 40, and the flow rate of the purge gas G2 in the third purge gas supply portion 42c, which is the closest to the purge gas introduction portion 40, can be made equal.

Therefore, it is possible to suppress the backflow of the purge gas G2 or the process gas G1 from the purge gas supply portion 42 to the buffer chamber 38. Therefore, since the adhesion of the by-products 56 to the light-transmitting window 46 is suppressed, it is possible to suppress a reduction in the accuracy of optical measurements.

From the viewpoint of suppressing the backflow of the purge gas G2 or the process gas G1 into the buffer chamber 38, it is preferable that the second distance d2 between the bottom surface of the protruding portion 46a and the bottom surface of the buffer chamber 38 is smaller than the first distance d1 between the side surface of the protruding portion 46a and the side surface of the buffer chamber 38. Since the conductance between the bottom surface of the protruding portion 46a and the bottom surface of the buffer chamber 38 becomes small, the flow rates of the purge gas G2 flowing to the plurality of purge gas supply portions 42 are easily equalized.

From the viewpoint of suppressing the backflow of the purge gas G2 or the process gas G1 into the buffer chamber 38, the second distance d2 between the bottom surface of the protruding portion 46a and the bottom surface of the buffer chamber 38 is preferably equal to or less than 2 mm, more preferably equal to or less than 1 mm. Since the conductance between the bottom surface of the protruding portion 46a and the bottom surface of the buffer chamber 38 becomes small, the flow rates of the purge gas G2 flowing to the plurality of purge gas supply portions 42 are easily equalized.

From the viewpoint of suppressing the backflow of the purge gas G2 or the process gas G1 into the buffer chamber 38, it is preferable that the second distance d2 between the bottom surface of the protruding portion 46a and the bottom surface of the buffer chamber 38 is smaller than the maximum opening width d4 of the purge gas supply portion 42. Since the conductance between the bottom surface of the protruding portion 46a and the bottom surface of the buffer chamber 38 becomes small, the flow rates of the purge gas G2 flowing to the plurality of purge gas supply portions 42 are easily equalized.

From the viewpoint of suppressing the backflow of the purge gas G2 or the process gas G1 into the buffer chamber 38, it is preferable that the bottom surface of the protruding portion 46a faces all regions of the openings of the plurality of purge gas supply portions 42 in the extending direction of the purge gas supply portions 42. In addition, from the viewpoint of suppressing the backflow of the purge gas G2 or the process gas G1 into the buffer chamber 38, it is preferable that when the shapes of the plurality of purge gas supply portions 42 are projected at the same size onto the bottom surface of the protruding portion 46a in the extending direction of the plurality of purge gas supply portions 42, the projected shape is included within the bottom surface of the protruding portion 46a. Since the conductance between the bottom surface of the protruding portion 46a and the bottom surface of the buffer chamber 38 becomes small, the flow rates of the purge gas G2 flowing to the plurality of purge gas supply portions 42 are easily equalized.

In addition, from the viewpoint of suppressing the backflow of the purge gas G2 or the process gas G1 into the buffer chamber 38, it is preferable that when the shapes of the plurality of purge gas supply portions 42 are projected at the same size onto the bottom surface of the protruding portion 46a in the extending direction of the plurality of purge gas supply portions 42, the fifth distance d5 and the sixth distance d6 between the projected shape and the outer periphery of the bottom surface of the protruding portion 46a are larger than the second distance d2 between the bottom surface of the protruding portion 46a and the bottom surface of the buffer chamber 38. Since the conductance between the bottom surface of the protruding portion 46a and the bottom surface of the buffer chamber 38 becomes small, the flow rates of the purge gas G2 flowing to the plurality of purge gas supply portions 42 are easily equalized.

From the viewpoint of suppressing the backflow of the purge gas G2 or the process gas G1 into the buffer chamber 38, it is preferable that the third distance d3 between the purge gas introduction portion 40 and the bottom surface of the buffer chamber 38 in the extending direction of the purge gas supply portion 42 is larger than the second distance d2 between the bottom surface of the protruding portion 46a and the bottom surface of the buffer chamber 38. Since the conductance between the purge gas introduction portion 40 and the third purge gas supply portion 42c closest to the purge gas introduction portion 40 becomes small, the flow rates of the purge gas G2 flowing to the plurality of purge gas supply portions 42 are easily equalized.

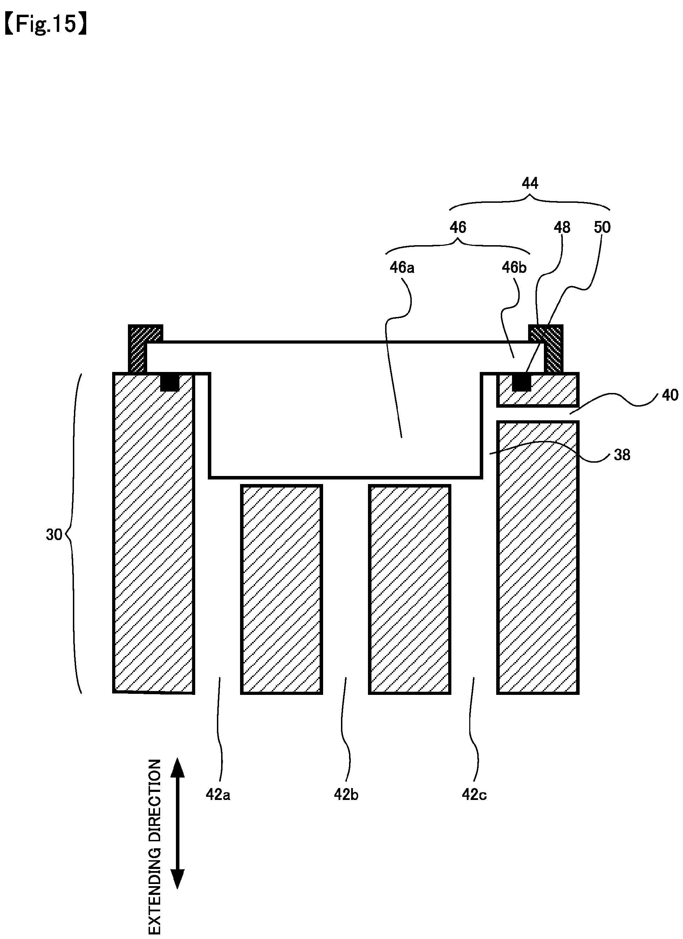

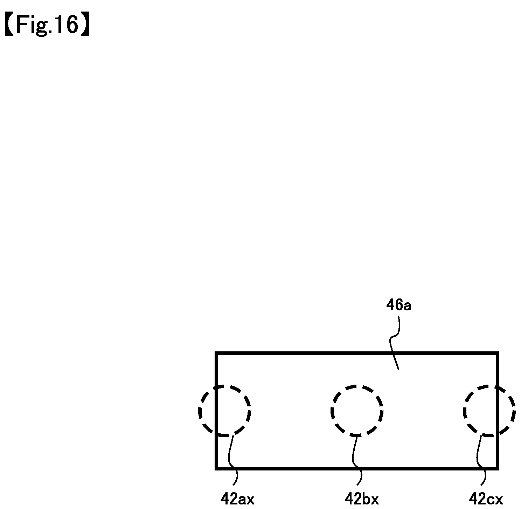

Fig. 15 is an enlarged schematic view of a part of a vapor phase growth apparatus according to a first modification example of the embodiment. Fig. 15 is a diagram corresponding to Fig. 3 of the embodiment. Fig. 16 is a schematic diagram when the shape of a gas exhaust portion in the first modification example of the embodiment is projected onto the bottom surface of a light-transmitting member. Fig. 16 is a diagram corresponding to Fig. 8 of the embodiment.

The vapor phase growth apparatus according to the first modification example is different from the vapor phase growth apparatus according to the embodiment in that, as shown in Fig. 15, the bottom surface of the protruding portion 46a does not face a part of the opening of the purge gas supply portion 42. In addition, the vapor phase growth apparatus according to the first modification example is different from the vapor phase growth apparatus according to the embodiment in that, as shown in Fig. 16, when the shape of the purge gas supply portion 42 is projected at the same size onto the bottom surface of the light-transmitting window 46 in the extending direction of the purge gas supply portion 42, a part of the projected shape of the purge gas supply portion 42 is not included within the bottom surface of the light-transmitting window 46.

Also in the vapor phase growth apparatus according to the first modification example, the flow rates of the purge gas G2 flowing to the plurality of purge gas supply portions 42 are more easily equalized than in the vapor phase growth apparatus 900 according to the comparative example.

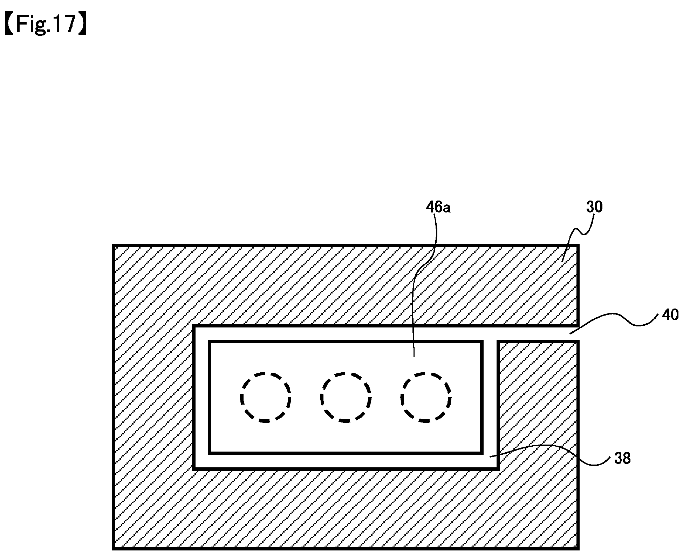

Fig. 17 is an enlarged schematic view of a part of a vapor phase growth apparatus according to a second modification example of the embodiment. Fig. 17 is a diagram corresponding to Fig. 6 of the embodiment.

The vapor phase growth apparatus according to the second modification example is different from the vapor phase growth apparatus 100 according to the embodiment in that, as shown in Fig. 17, the purge gas introduction portion 40 does not face the side surface of the protruding portion 46a.

Also in the vapor phase growth apparatus according to the second modification example, the flow rates of the purge gas G2 flowing to the plurality of purge gas supply portions 42 are more easily equalized than in the vapor phase growth apparatus 900 according to the comparative example.

Up to now, the embodiments of the invention have been described with reference to specific examples. The above embodiments are merely given as examples, and do not limit the invention. In addition, the components of the embodiments may be combined as appropriate.

In the embodiments, the case of forming a single crystal silicon carbide film has been described as an example. However, the invention can also be applied to a vapor phase growth apparatus for forming a film other than the single crystal silicon carbide film.

In addition, in the embodiments, the wafer formed of single crystal silicon carbide has been described as an example of the substrate. However, the substrate is not limited to the wafer formed of single crystal silicon carbide.

In the embodiments, the description of parts that are not directly required for the description of the invention, such as an apparatus configuration, a manufacturing method, and an optical measurement method, is omitted. However, the required apparatus configuration, manufacturing method, optical measurement method, and the like can be appropriately selected and used. In addition, all vapor phase growth apparatuses that include the elements of the invention and that can be appropriately redesigned by those skilled in the art are included in the scope of the invention. The scope of the invention is defined by the scope of claims and the scope of their equivalents.

### EXPLANATIONS OF LETTERS OR NUMERALS

- 10: CHAMBER

- 12: HOLDER
- 30: HEAD UNIT
- 36: PROCESS GAS SUPPLY PORTION
- 38: BUFFER CHAMBER (RECESS)
- 40: PURGE GAS INTRODUCTION PORTION (GAS INTRODUCTION PORTION)
- 42: PURGE GAS SUPPLY PORTION (GAS SUPPLY PORTION)
- 46: LIGHT-TRANSMITTING WINDOW (LIGHT-TRANSMITTING MEMBER)
- 46a: PROTRUDING PORTION (PORTION)
- 54: MEASURING INSTRUMENT
- 100: VAPOR PHASE GROWTH APPARATUS
- W: WAFER (SUBSTRATE)
- G2: PURGE GAS (GAS)
- d1: FIRST DISTANCE
- d2: SECOND DISTANCE
- d3: THIRD DISTANCE
- d4: MAXIMUM OPENING WIDTH

## Claims

1. A vapor phase growth apparatus, comprising:
a chamber having a head unit at an upper portion of the chamber, processing on a wafer being performed inside the chamber;
a process gas supply portion provided in the head unit to supply a process gas into the chamber;
a recess provided in an upper surface of the head unit;
a light-transmitting member including a portion surrounded by the recess, a first distance between a side surface of the portion and a side surface of the recess being larger than a second distance between a bottom surface of the portion and a bottom surface of the recess;
a gas introduction portion provided in the head unit to introduce a gas between the side surface of the recess and the side surface of the portion; and
a plurality of gas supply portions provided in the head unit and connecting the recess and the chamber to each other to supply the gas into the chamber.

2. The vapor phase growth apparatus according to claim 1,
wherein the bottom surface of the portion faces all regions of openings of the plurality of gas supply portions.

3. The vapor phase growth apparatus according to claim 1,
wherein the second distance is smaller than a maximum opening width of the plurality of gas supply portions.

4. The vapor phase growth apparatus according to claim 2,
wherein the second distance is smaller than a maximum opening width of the plurality of gas supply portions.

5. The vapor phase growth apparatus according to claim 1, further comprising:
a measuring instrument provided above the light-transmitting member.

6. The vapor phase growth apparatus according to claim 2, further comprising:
a measuring instrument provided above the light-transmitting member.

7. The vapor phase growth apparatus according to claim 1,
wherein the light-transmitting member further includes a flange, and the flange is placed at an end of the recess.

8. The vapor phase growth apparatus according to claim 2,
wherein the light-transmitting member further includes a flange, and the flange is placed at an end of the recess.
